(19) Europäisches Patentamt
European Patent Office
Office européen des brevets

(11) **EP 0 383 260 B1**

(12) **EUROPEAN PATENT SPECIFICATION**

(45) Date of publication and mention
of the grant of the patent:
**16.04.1997 Bulletin 1997/16**

(51) Int Cl.⁶: **G06F 5/06**, G06F 11/10

(21) Application number: **90102798.7**

(22) Date of filing: **13.02.1990**

(54) **Elastic buffer circuit**

Elastische Pufferspeicher

Circuit de tampon élastique

(84) Designated Contracting States:
**DE FR GB**

(30) Priority: **13.02.1989 JP 31018/89**

(43) Date of publication of application:
**22.08.1990 Bulletin 1990/34**

(73) Proprietor: **KABUSHIKI KAISHA TOSHIBA**
**Kawasaki-shi, Kanagawa-ken 210 (JP)**

(72) Inventor: **Tanaka, Koichi**
**Nakahara-ku, Kanagawa-ken (JP)**

(74) Representative: **Lehn, Werner, Dipl.-Ing. et al**
**Hoffmann, Eitle & Partner,**
**Patentanwälte,**
**Postfach 81 04 20**
**81904 München (DE)**

(56) References cited:
**EP-A- 0 217 486        US-A- 4 095 283**
**US-A- 4 556 960**

• **PATENT ABSTRACTS OF JAPAN vol. 12, no. 413**
**(P-780)(3260) 2 November 1988 & JP-A-63 150**
**747 ( TOSHIBA )**

# Description

## BACKGROUND OF THE INVENTION

### Field of the invention

The present invention relates to an elastic buffer circuit of a type specified in the preamble of claim 1.

### Description of the Prior Art

An elastic buffer of the type mentioned above is known from EP-A-0 217 486.

Moreover, it is known from US-A-4,056,851 to provide in digital communication devices, for example in a composition shown in Fig. 1 of the drawings, an eleastic buffer circuit to be inserted into an input and output path to perform delay control of communication data.

In this diagram, the delay buffer circuit has a memory portion 1 for containing input data and then outputting the data, a writing pointer 3 for controlling writing of the input data inputted in the memory portion 1, a reading pointer 5 for controlling reading of the data outputted from the memory portion 1 and an error detector 7 for detecting errors in the writing and reading operation.

In the memory portion 1, data to be inputted therein are successively written in memory elements selected from n memory elements ( a position #0 to a positon #n-1) by a decoder 9. Then, the data written in the memory elements are selected by a selector 13, and then outputted as output data.

Namely, a binary number of from 0 to n-1 each designating a number of each memory element {where the binary number is a number of m figures ($n \leq 2^m$), and will be called as "writing position code" hereinafter} is outputted from the writing pointer 3 in synchronism with an input clock. Then, each the writing position code is decoded by the decoder 9, thereafter input data are successively contained into the memory elements based on each the decoded result.

While, a binary number of from 0 to n-1 each designating a number of each the memory element (the binary number will be called as "reading position code" hereinafter) is outputted from the pointer 5. Then, data having been written in the respective memory elements are selected and outputted based on the respective reading position codes by the selector 13.

In such delay operation of the input data, at a starting time of the operation, a code having an interval of n/2 to an initial code of the reading pointer 5 is set as a writing initial code of the writing pointer 3, where n is the number of the memory elements. For example, assume that the number of memory elements is 12 (n = 12). When the input data are successively contained in the memory elements from the one corresponding to a position #0 based on the writing position codes, the output data are successively read out from the memory elements from the one corresponding to a position #6 based on the reading position codes. In such a manner, it is attempted to make a frequency variation of the input clock to the output clock be absorbed by setting the interval between the reading position code and the writing position code sufficiently large.

However, in the elastic buffer circuit comprising the above-mentioned composition, the frequency variations of the input clock and the output clock cause errors such as under flow on which the number of data to be contained in the memory elements becomes less than 0 and overflow on which the number of data becomes greater than n.

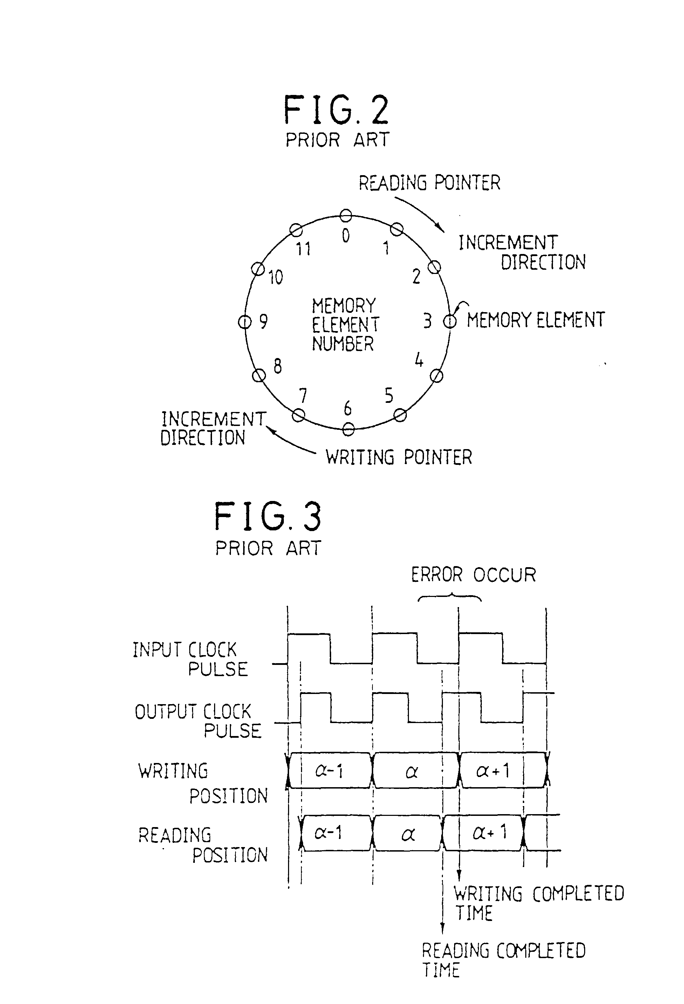

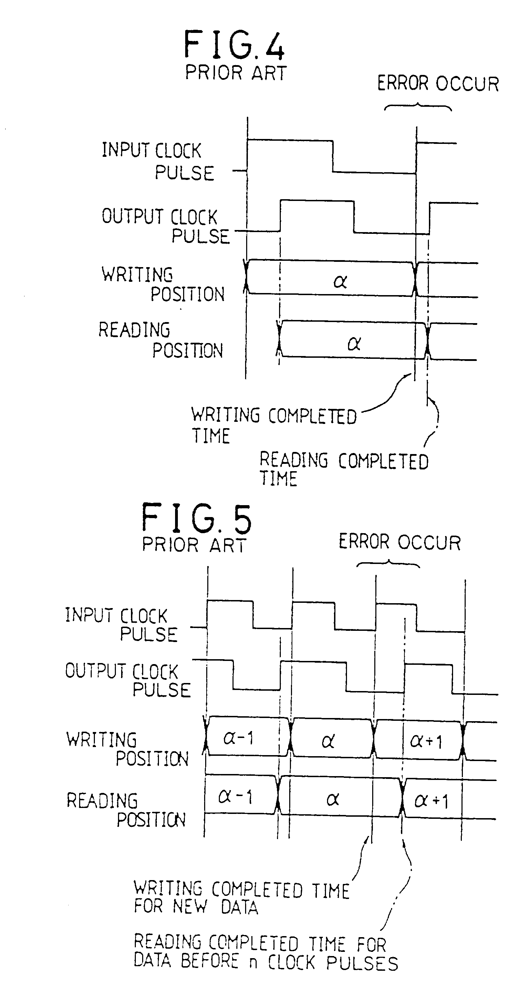

For example, in case of such a frequency variation that a frequency of the input clock is a little lower than that of the output clock, the number of data to be contained is gradually reduced and finally becomes less than 0. At the time, when the writing pointer 3 and the reading pointer 5 designate the same memory element, as shown in Fig. 3, since a frequency of the output clock is high, an underflow error that data are read before completion of the writing of the data into the memory elements is caused. Otherwise, the reading is carried out immediately after the completion of the writing as shown in Fig. 4, thus it becomes difficult to stably output the data.

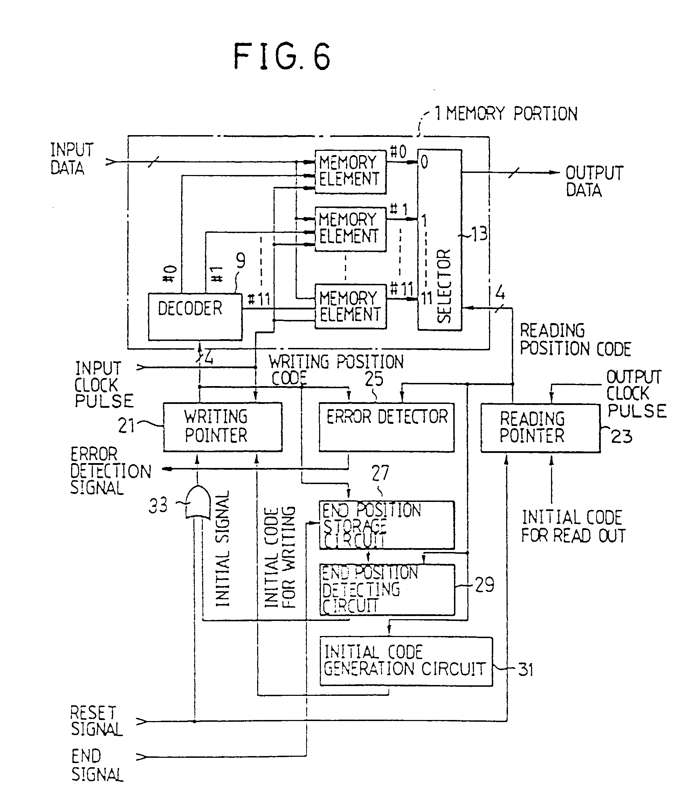

While, in case of such a frequency variation that a frequency of the input clock is a little higher than that of the output clock, the number of data to be written is gradually increased and finally becomes greater than n. At the time, when the writing pointer 3 and the reading pointer 5 designate the same memory element, as shown in Fig. 5, an overflow error that next data are written in the same memory element before completion of reading of data.

By the way, such errors are to be detected by the error detector 7. When the error detector 7 detects an error, it outputs an error detective signal on condition that either equation of

$$k = \ell \ (k\text{-}\ell = 0)$$

when the overflow error is caused, or

$$k = \ell\text{-}1 \ (k\text{-}\ell = 1)$$

when the underflow error is caused is established. Where k is a position of the memory element designated by the writing pointer 3, and $\ell$ is a position of the memory element designated by the reading pointer 5.

When a frequency variation occurs in the input clock or the output clock, such an error as mentioned above is likely to be caused. Accordingly, when the error is caused, the writing and the reading should be stopped for a while, and the writing position code and the reading position code must be initialized and returned to their normal operation.

As stated above, the detection of the error is carried out by obtaining the difference between the writing position code and the reading position code respectively circulating from 0 to n-1 and judging whether the difference is 0 or 1. Thus, complex composition should be required for the circuits for calculating the difference of the codes respectively circulating from 0 to n-1.

Moreover, the writing position code and the reading position code are respectively composed of a plurality of bits so that the difference therebetween is also composed of a plurality of bits. Accordingly, the values of a plurality of bits for designating the difference are not stably fixed until the input and the output operation of the data are completed and the respective position codes are fixed. The error detection signal is outputted at the time. However, since the input and the output operation are carried out at different timing respectively based on the clocks including frequency variations, it is extremely difficult to obtain timings for stably fixing the difference of the respective position codes. Therefore, it is difficult to distinctly judge whether the difference is 0 or 1, thus the error can not be detected correctly.

While, initialization of the pointing means as above described the writing pointer and the reading pointer should be suitably carried out not only at a starting time of the operation but also after detection of the error and at normalizing the delay time. However, since the number of data in memory elements is not fixed for reasons of frequency variations, it is extremely difficult to initialize the distance of both the position codes without losing valid data. For example, when the number of the valid data is more than n/2 and the distance of both the positions is set at n/2, a portion of the valid data are inevitably lost.

Moreover, when the initialization is carried out during operation of the elastic buffer circuit, in order to set a code obtained by addition of n/2 to a reading initial code of the reading pointer 5 as a writing initial value of the writing pointer 3, an additional circuit for calculating the above code should be required. Therefore, a size of the circuit must be increased so much. Incidentally, the additional operation must be accompanied by a plurality of bits, and each bit is not fixed at the same timing. Furthermore, since the calculation to decide a timing of the initialization is not carried out in synchronism with the input clock, the initial code is not occasionally set as a correct writing initial code. In this case, normal operation can not be obtained even when the pointing means are initialized.

## SUMMARY OF THE INVENTION

It is an object of the present invention to provide an elastic buffer circuit of the type initially mentioned hereinabove which cannot only perform stable error detection with simple circuit composition, but also can perform correct initialization.

This object can be achieved by a circuit as specified in claim 1.

Further improvements thereof are specified in the sub-claims.

To achieve the above object, a preferred embodiment of a delay buffer circuit according to the present invention comprises a plurality of memory means for successively writing and then outputting data, writing designation means for successively and circulatingly designating the memory means for writing data in synchronism with a first clock based on codes for designating the memory means being two consecutive codes having Hamming distance of 1, reading designation means for successively and circulatingly designating the memory means for reading data in synchronism with a second clock based on the codes, and error detective means for detecting an error when a code designated by the reading designation means has a common code assigned a code designated by the writing designation means, these common codes are common bits in a pair of the codes corresponding to adjacent pair of the memory means.

As stated above, the difference between each pair of the codes for designating two consecutive memory means is 1 bit. By using such codes, errors are detected when the memory means which has been designated by the writing designation means is the same as or one memory means before the memory means which has been designated by the reading designation means.

Incidentally, another preferred embodiment of the present invention comprises a plurality of memory means for successively writing and then outputting data, writing designation means for successively and circulatingly designating the memory means for writing data in synchronism with a first clock based on codes for designating the memory means being two consecutive codes having Hamming distance of 1, reading designation means for successively and circulatingly designating the memory means for reading data in synchronism with a second clock based on the codes, error detective means for detecting an error when a code designated by the reading designation means has a common code assigned a code designated by the writing designation means, the common codes are common bits in a pair of the codes corresponding to adjacent pair of the memory means, initialization means which contains a code for designating the memory means in which data are written when a final signal is given, and which performs initialization when the code correspondes to the same common code with a code designated by the reading designation means, and initial code setting means for setting an initial code in the writing designating means, this initial code is obtained as a result of a logical operation between a code designated by the reading designation means just before the initialization and a predetermined code. Accordingly, the initialization is carried out when a code fordesignating reading become the common code corresponding to a code for designating memory means in which data are written just when the end signal is given and the initial code is generated by using the code for designating reading on the initialization.

As stated above, since a delay buffer circuit of the present invention is so arranged as to perform error detection by using codes for designating memory means being two consecutive codes having Hamming distance of 1, the circuit can be composed of simple circuit composition and guarantee stable and correct error detection. Moreover, since the initialization is carried out after the valid data written in the memory means are read out positions of memory means in which are written valid data are memorized, and the initial code is set based on the code for designating reading, most suitable initialization can be certainly carried out.

These and other objects, features and advantages of the present invention will be more apparent from the following description of a preferred embodiment, taken in conjunction with the accompanying drawings.

BRIEF DESCRIPTION OF THE DRAWINGS

Fig. 1 is a compositional diagram of a conventional elastic buffer circuit.

Fig. 2 is a diagram to show a relation between a reading pointer and a writing pointer of the elastic buffer circuit shown in Fig. 1.

Figs. 3, 4 and 5 are timing charts to respectively show operation on error generation in the elastic buffer circuit shown in Fig. 1.

Fig. 6 is a compositional diagram of a elastic buffer circuit as an embodiment of the present invention.

Fig. 7 is a diagram to show position codes to be used in the elastic buffer circuit shown in Fig. 6.

Figs. 8, 9 and 10 are timing charts to respectively show operation of the elastic buffer circuit shown in Fig. 6.

DETAILED DESCRIPTION OF THE EMBODIMENT

Hereinafter, embodiments of the present invention will be described with respect to drawings.

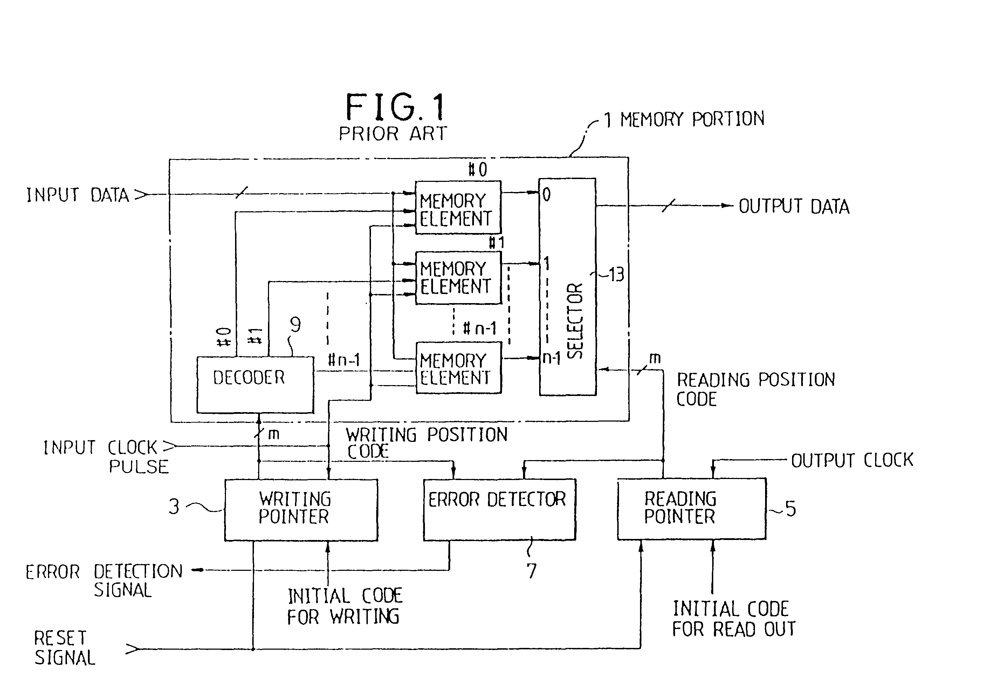

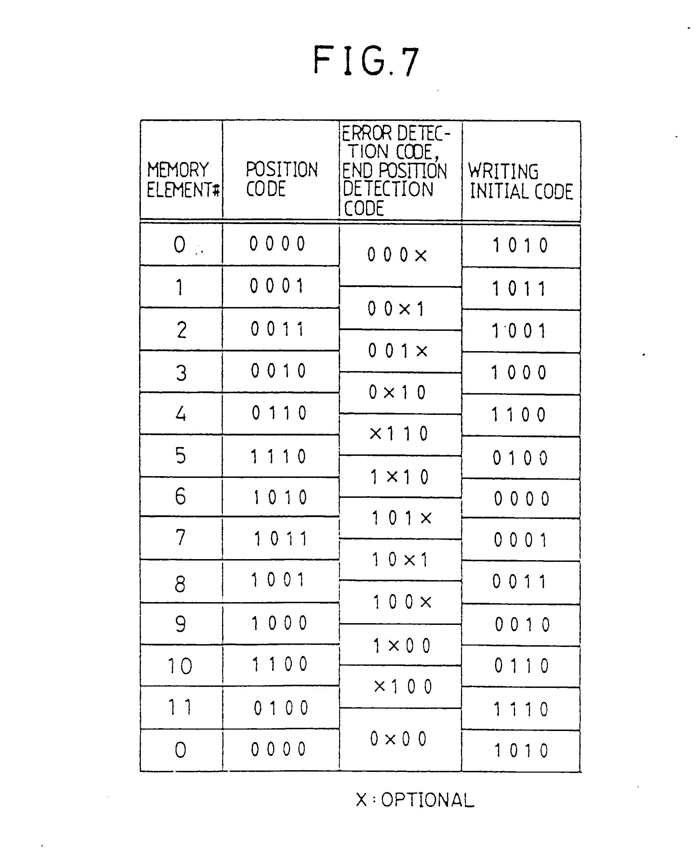

Fig. 6 is a block diagram to show composition of a elastic buffer circuit as an embodiment of the present invention. The elastic buffer circuit has 12 memory elements as memory means. Incidentally, in Fig. 6, each function designated by the same reference numeral or character presents the same function as in Fig. 1, thus explanation thereon will be omitted. Besides the memory portion 1 shown in Fig. 1, the elastic buffer circuit of the present invention comprises a writing pointer 21 as writing designation means, a reading pointer 23 as reading designation means, an error detector 25 as error detective means, a end position storage circuit 27, a end position detecting circuit 29 and a initial code generate circuit 31. The writing pointer 21 designates memory elements for containing (writing) input data with the output of the decoder 9 of the writing position codes and performs count-up in synchronism with rise of an input clock as a first clock and designates memory elements for containing next input data. With respect to the position code, Hamming distance of each the code to select memory elements being next to each other is set at 1. Fig. 7 is a diagram to show position codes to be used in the embodiment. With respect to these writing position codes, an exclusive OR of each pair of codes, the interval between of which is 1/2 of the number of all the memory elements, is set to be always a predetermined value (the value is 1010 in the embodiment).

When a reset signal as a command for starting of operation or an initializing signal to be generated by a end position detecting circuit 29 is given to an OR gate 33, a writing initial code shown in Fig. 7 is given and set in the writing pointer 21 from the initial code generate circuit 31 in accordance with a present value of the reading pointer 23.

The reading pointer 23 performs count-up output of a reading position code in synchronism with rise of an output clock as a second clock. Memory elements contained data are designated by a selector 13 by decoding of the reading position code. At the time, the reading position code is set in the same manner as the writing position code. When the reset signal is given from an external portion, a reading initial code, for example 0000, is set in the reading pointer 23.

The error detector 25 detects overflow or underflow, and outputs an error detective signal in synchronism with the input clock when a position of a memory element designated by the writing pointer 21 becomes the same position of a memory element designated by the reading pointer 23 or when a difference between these two positions is 1.

Since each Hamming distance of both the adjacent position codes is 1, whether each of the above conditions is established or not can be judged by a 3 bits of code (hereinafter the code will be called error detective code) which is a common code comprising exception of a different 1 bit in 4 bits of each code. Such an error detective code is set corresponding to each adjacent pair of position codes as shown in Fig. 7. In Fig. 7, mark X in each the error detective code shows the above-mentioned different 1 bit.

For example, in case that the writing pointer 21 designates a memory element position #0, error is generated when the reading pointer 23 designates the memory element position #0 or a memory element position #1, and an error detective code at the time is 000X. Accordingly, in such a case, the error detector 25 detects whether the first 3 bits of the reading position code is 000 or not.

While, the error detector 25 generates an error check signal for each the error detective code corresponding to each the writing position code. Each the error check signal is in a high-level state and outputted when the reading position code becomes the same as each the error detective code.

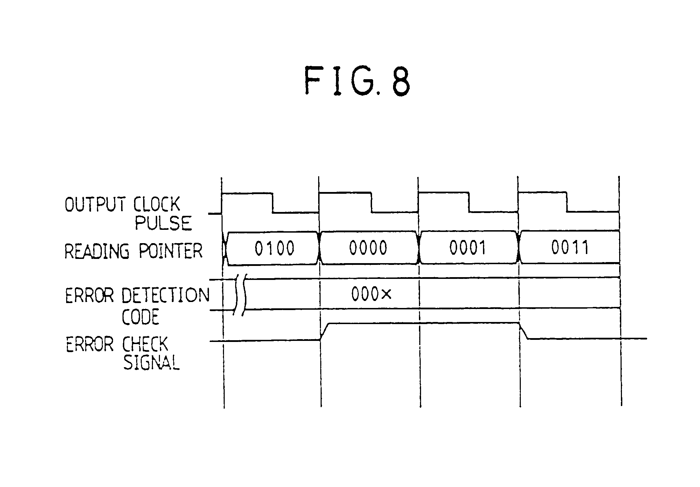

For example, an error check signal corresponding to the error detective code 000X is in a high-level state and outputted when a reading position code outputted from the reading pointer 23 becomes 0000 or 0001 as shown in Fig. 8. The error detector 25 selects such a plurality of error check signals in accordance with the writing position codes. Then, the detector 25 outputs error the selected error check signals as error detective signals in synchronism with the input clock.

The end position storage circuit 27 contains position codes to indicate memory elements in which a final valid data is contained on the initialization of the elastic buffer circuit. Namely, at a time when a final signal is given from an external portion on the initialization, the end position storage circuit 27 contains writing position codes outputted from the writing pointer 21. The codes contained in the end position storage circuit 27 are outputted into the end position detecting circuit 29. The circuit 29 has a function for generating timing of initialization after the final valid data are read. The circuit 29 outputs an initialization signal to the OR gate 33 when a position of a memory element designated by the reading pointer 23 become the same position of a memory elements in which the final valid data are contained,or when a difference between the two positions is 1. Such operation is carried out by using the same code as an error detective code, as shown in Fig. 7, for end detective code. Namely, the end detecting circuit 29 detects accord and discord of the 3 bits in both the end detective code corresponding to code contained in the end position storage circuit and the reading position code outputted by the reading pointer 23, then outputs the initialization signal.

The initial code generate circuit 31 sets a writing initial code in the writing pointer 21 corresponding to the present value of the reading pointer 23 when the reset signal or the initialization signal is outputted. The writing initial code in the embodiment is a code corresponding to a memory element designated by a sixth position(i.e, +6) from a position of a memory element designated by the reading pointer. The initial code generate circuit 31 generates an initial code by an exclusive OR between a position code given by the reading pointer 23 and the above-mentioned predetermined code (1010) for provision of the position code.

Next, operation of the embodiment will be described in consideration of the initialization operation and error detective operation thereof.

First, the reset signal is given to the reading pointer 23 before operation of the elastic buffer circuits is started, thereby setting 0000 as a reading initial code in the reading pointer 23. The reading initial code is also given to the initial code generate circuit 31, and an exclusive OR of the code and the predetermined code 1010 is obtained. Namely, the operational result of the exclusive OR designates a memory element position #6 designated by a code 1010 which is the sixth position from the memory element positon #0 designated by the reading position code 0000.

The code 1010 is set as a writing initial code in the writing initial pointer 21. Accordingly, the interval of both the memory elements respectively designated by the reading pointer 23 and the writing pointer 21 becomes 6.

When an input clock is given to the writing pointer 21, input data are contained in memory elements respectively corresponding to the writing position codes in synchronism with the input clock and the writing position code are counted up for next input data. Moreover, when an output clock is given to the reading pointer 23, data contained in memory elements respectively corresponding to the reading position codes are outputted in synchronism with the output clock through the selector 13 and the reading position code are counted up for next output data.

In such a manner, input data are successively contained in memory elements, then the contained data are delayed and outputted in the order of the containment thereof.

In such operation for the elastic buffer curcuit, when frequency variation is generated in the input clock or output clock, the difference between a position of a memory element designated by the writing pointer 21 and a position of a memory element designated by the reading pointer 23 becomes small, both the positions become near to each other. When the difference becomes 1 or 0, an error check signal corresponding to the writing position code is selected. The error check signal is outputted as an error detective signal in synchronism with the input clock. Thus, the error detection is completed.

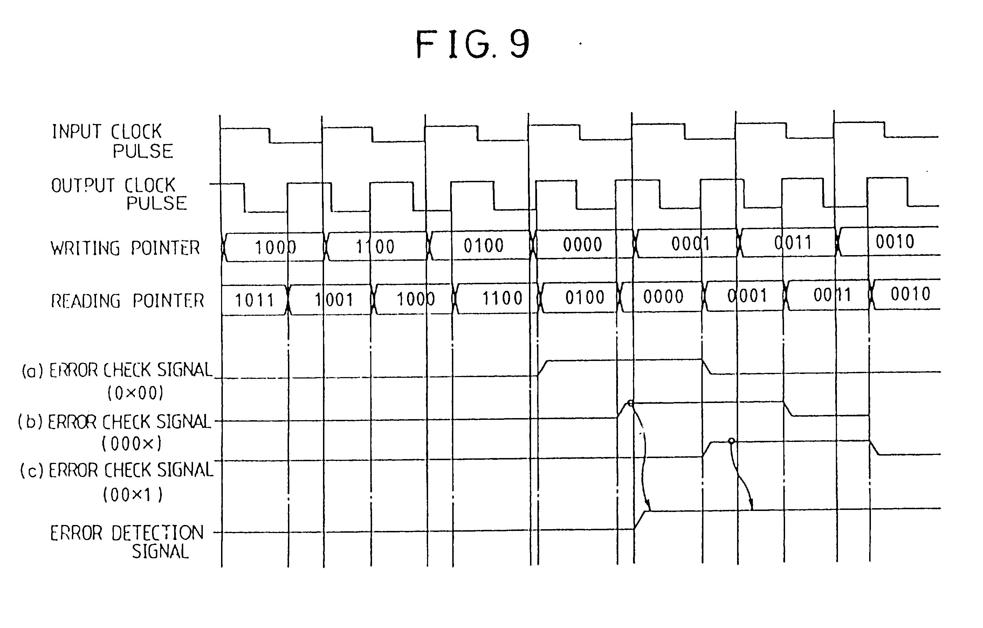

For example, when the writing position code outputted from the writing pointer 21 and the reading position code outputted from the reading pointer 23 are varied as shown in Fig. 9, timing charts of error check signals (a), (b) and (c) respectively corresponding to error detective codes 0X00, 000X and 00X1 become as shown in Fig. 9. Of these error check signals, the error check signals (b) and (c) are selected according to the writing position code outputted from the writing pointer 21, 21, (because an error detective signal according to the writing position code "0000" is "000X" and an error detective signal according to the writing position code "0001" is "00X1"), thus an error detective signal as shown in Fig. 9 is outputted.

Since, an error is detected by selection of the error check signal using the position code in which only one bit is varied, no hazard is caused in operation for the error detection. Accordingly, the delay buffer circuit in the embodiment can perform stable and certain error detection, though errors can not be judged until an operational result of a plurality of bits becomes stable in the conventional one.

Next, when a final signal is given to the end position storage circuit 27 during the operation, it contains a writing position code for designating a memory element in which final valid data are contained. Then, an initial code is outputted when a position designated by the reading position code is the same as a position designated by the code contained in the end position storage circuit 27 or when the difference of these positions is 1, then initialization is completed.

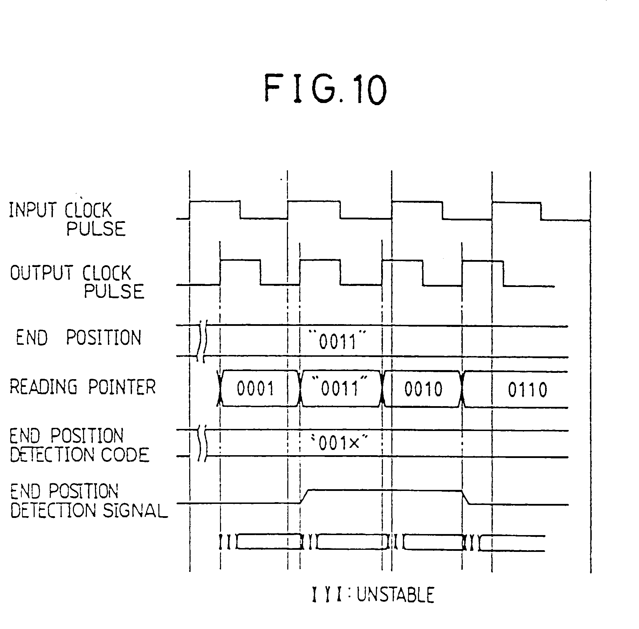

For example, when a writing position code of 0011 is contained in the end position storage circuit 27 as shown in Fig. 10 , a end position detective code suitable in the case is 001X which corresponds to this code or a code for designating the next position to this code. Accordingly, when the reading position codes are 0011 and 0010, an end position detective signal is outputted as shown in Fig. 10. Thus, an initial signal is given to the OR gate 33 from the end position detecting circuit 29, and the initialization is completed.

As stated above, since judgement for reset operation is also carried out by using variation of 1 bit in the reading position code in addition to judgement for the error detection, hazard is not caused in decision of the reset timing. Thus, the reset operation can be performed at a stable and most suitable timing on output of data without considering the number of data contained before reset.

Incidentally, a reading position code is given to the initial code generate circuit 31 when a reset signal is given to the reading pointer 23. Then, the exclusive OR of the code given to the initial code generate circuit 31 and the predetermined code 1010 is taken, and the result of operation is set as a writing initial code in the writing pointer 21. At the time, even in case that the initial code is set in the writing pointer 21 as soon as a reading position code outputted from the reading pointer 23 is varied, the variation of the reading position code is only 1 bit. Therefore, the variation of the initial code also becomes 1 bit, and a position which is next to an aimed position is certainly set. Accordingly, even when the reset operation is carried out in operation, a most suitable writing initial code can be obtained as compared with the conventional case.

As the result, the reset operation can be performed at a most suitable timing irrespectively of variations of the number of data to be contained and frequency of the input clock and the output clock, further operation for input and output after the reset operation can be started from a most suitable position.

Incidentally, the present invention is not limited as described in the above embodiment. For example, any code rows of the position code other than that in Fig. 7 may be taken to obtain the similar effect so far as Hamming distance between each adjacent pair thereof is 1.

Also, the number of the memory elements is not limited as described in the embodiment, and suitable position codes may be selected for variation of the number. Moreover, the predetermined code for the exclusive OR between the reading position code when the writing initial code is obtained is not limited in 1010 in the embodiment.

Furthermore, in the embodiment, the judgement of the reset timing is carried out when the end position is in accordance with the reading position. However, the reset may be carried out when the reading position reaches a position at a predetermined interval from the end position.

## Claims

1. An elastic buffer circuit, comprising

   memory means for storing and outputting data, including a plurality of memory elements (#0, #1, ..., #11);

   writing designation means (21) for designating adjacent memory elements of said memory means by writing position address codes having a predetermined number of bits and a Hamming distance of 1; and

   reading designation means (23) for designating adjacent memory elements of said memory means by reading position address codes having a predetermined number of bits and a Hamming distance of 1;

   **characterized** in that

   said writing designation means (21) are provided for successively and circulately designating memory elements of said memory means to store input data in synchronism with a first clock pulse;

   said writing position address codes include common codes, in which all the bits other than one bit of said writing position address codes corresponding to adjacent memory elements of said memory means, are the same;

   said reading designation means (23) are provided for successively and circulately designating memory elements of said memory means to read output data in synchronism with a second clock pulse;

   said reading position address codes include common codes, in which all the bits other than one bit of said reading position address codes corresponding to adjacent memory elements of said memory means, are the same; and

   additional means are provided as follows:

   detecting means (25) for detecting as errors occurrences when the common address code of a reading position address code of a memory element designated by the reading designation means (23) is the same as the common address code of a writing position address code of a memory element designated by the writing designation means (21);

initialization means (27, 29) for storing the writing position address code designating the memory element for storing data when an end signal is provided, and for initializing the contents of the writing designation means when the stored writing position address code and the code designated by the reading designation means (23) have the same common address; and

initial code setting means (31) for setting into the writing designation means (21) an initial code obtained as an output signal from logic operation means receiving a code designated by the reading designation means (23) and a predetermined code.

2. The elastic buffer circuit as recited in claim 1, characterized in that the memory element position designated by the writing designation means (21) on the basis of the output of the logical operation means in the initial code setting means (31), is separated by the nearest one half of the number of memory elements from the memory element position designated by the reading designation means (23).

3. The elastic buffer circuit as recited in claim 1, characterized in that the writing designation means (21) are provided for operating so that an exclusive OR of a pair of memory position codes, for designating memory elements, the interval between which is nearest to a half of the number of all the memory elements, always has a predetermined value.

**Patentansprüche**

1. Elastische Pufferschaltung, enthaltend:

eine Speichervorrichtung zum Speichern und Ausgeben von Daten, einschließlich mehrerer Speicherzellen (#0, #1, ..., #11);

eine Schreibbestimmungsvorrichtung (21) zum Bestimmen benachbarter Speicherelemente der Speichervorrichtung durch Schreiben von Positionsadressencodes mit einer festgelegten Zahl von Bits und einer Hamming-Distanz von 1; und

eine Lesebestimmungsvorrichtung (23) zum Bestimmen benachbarter Speicherelemente der Speichervorrichtung durch Lesen von Positionsadressencodes mit einer festgelegten Zahl von Bits und einer Hamming-Distanz von 1;

dadurch gekennzeichnet, daß

in der Schreibbestimmungsvorrichtung (21) zum sukzessiven und zirkulationsartigen Bestimmen von Speicherelementen der Speichervorrichtung für die Speicherung von Eingangsdaten synchron mit einem ersten Taktimpuls ausgebildet ist;

die Schreibpositions-Adressencodes gemeinsame Codes enthalten, in denen alle Bits anders als das eine Bit des Schreibpositions-Adressencodes gemäß der benachbarten Speicherelemente der Speichervorrichtung übereinstimmen;

die Lesebestimmungsvorrichtung (23) zum sukzessiven und zirkulationsartigen Bestimmen von Speicherelementen der Speichervorrichtung zum Auslesen von Daten synchron mit einem zweiten Taktimpuls ausgebildet ist;

die Lesepositions-Adressencodes gemeinsame Codes enthalten, bei denen alle Bits anders als das eine Bit der Lesepositions-Adressencodes gemäß benachbarter Speicherelemente der Speichervorrichtung übereinstimmen; und

zusätzliche Vorrichtungen wie folgt vorgesehen sind:

eine Detektorvorrichtung (25) zum Detektieren des Auftretens von Fehlern dann, wenn der gemeinsame Adressencode eines Lesepositions-Adressencodes in einem Speicherelement, der durch die Lesebestimmungsvorrichtung (23) bestimmt ist, mit demjenigen des gemeinsamen Adressencodes eines Schreibpositions-Adressencodes eines eines Speicherelements übereinstimmt, der durch die Schreibbestimmungsvorrichtung (21) bestimmt ist;

eine Initialisierungsvorrichtung (27, 29) zum Speichern des Schreibpositions-Adressencodes zum Bestimmen des Speicherelements zum Speichern der Daten dann, wenn ein Signal gebildet wird, und zum Initialisieren der Inhalte der Schreibbestimmungsvorrichtung dann, wenn der gespeicherte Schreibpositions-Adressencode und der durch die Lesebestimmungsvorrichtung (23) bestimmte Code die gleiche gemeinsame Adresse aufweisen; und

eine Anfangscode-Einstellvorrichtung (31) zum Einstellen eines Anfangscodes bei der Schreibbestimmungsvorrichtung (21), der als Ausgangssignal einer Logikverknüpfungsvorrichtung erhalten wird, die einen durch die Lesebestimmungsvorrichtung (23) bestimmten Code und einen festen Code empfängt.

2. Elastische Pufferschaltung nach Anspruch 1, dadurch gekennzeichnet, daß die durch die Schreibbestimmungsvorrichtung (21) auf Basis des Ausgangsignals der Logikbetriebsvorrichtung in der Anfangscode-Einstellvorrichtung (31) bestimmte Speicherelementposition von der nächstliegenden um die Hälfte der Zahl der Speicherelemente von der Speicherelementposition getrennt ist, die durch die Lesebestimmungsvorrichtung (23) bestimmt ist.

3. Elastische Pufferschaltung nach Anspruch 1, dadurch gekennzeichnet, daß die Schreibbestimmungsvorrichtung (21) für einen Betrieb derart ausgebildet ist, daß eine exklusive ODER-Verknüpfung eines Paars von Speicherpositionscodes zum Bestimmen von Speicherelementen, zwischen denen das Intervall am nächsten bei der Hälfte der Zahl aller Speicherelemente liegt, immer einen festgelegten Wert aufweist.

**Revendications**

1. Mémoire tampon comprenant :

des moyens de mémoire pour mémoriser et sortir des données, comprenant une pluralité d'éléments mémoire (#0, #1, ..., #11) ; un moyen de désignation d'écriture (21) pour désigner des éléments mémoire adjacents desdits moyens de mémoire par des codes d'adresse de position d'écriture ayant un nombre prédéterminé de bits et une distance de Hamming de 1, et un moyen de désignation de lecture (23) pour désigner des éléments mémoire adjacents desdits moyens de mémoire par des codes d'adresse de position de lecture ayant un nombre prédéterminé de bits et une distance de Hamming de 1 ;

caractérisé en ce que

lesdits moyens de désignation d'écriture (21) sont prévus pour désigner successivement et par décalage circulaire les éléments de mémoire desdits moyens de mémoire afin de mémoriser les données d'entrée en synchronisme avec une première impulsion d'horloge ; lesdits codes d'adresse de position d'écriture comprennent des codes communs, dans lesquels tous les bits autres qu'un bit desdits codes d'adresse de position d'écriture correspondant auxdits éléments de mémoire adjacents desdits moyen de mémoire sont les mêmes ; lesdits moyens de désignation de lecture (23) sont prévus pour désigner successivement et par décalage circulaire les éléments de mémoire desdits moyens de mémoire pour extraire les données en synchronisme avec une seconde impulsion d'horloge ; lesdits codes d'adresse de position de lecture comprennent des codes communs, pour lesquels tous les bits autres qu'un bit desdits codes d'adresse de position de lecture correspondant auxdits éléments mémoire adjacents desdits moyens de mémoire sont les mêmes ; et des moyens supplémentaires sont prévus comme suit : des moyens de détection (25) pour détecter la présence d'erreurs lorsque le code d'adresse commun d'un code d'adresse de position de lecture d'un élément mémoire désigné par les moyens de désignation de lecture (23) est le même que le code d'adresse commun du code d'adresse de position d'écriture d'un élément mémoire désigné par le moyen de désignation d'écriture (21) ; des moyens d'initialisation (27, 29) pour mémoriser le code d'adresse de position d'écriture désignant l'élément mémoire pour mémoriser les données lorsqu'un signal de fin est délivré et pour initialiser les contenus des moyens de désignation d'écriture lorsque le code d'adresse de position d'écriture mémorisé et le code désigné par les moyens de désignation de lecture (23) ont la même adresse commune ; et des moyens d'établissement de code initial (31) pour établir dans les moyens de désignation d'écriture (21) un code initial obtenu comme un signal de sortie provenant d'un moyen d'opération logique recevant un code désigné par les moyens de désignation de lecture (23) et un code prédéterminé.

2. Circuit mémoire tampon selon la revendication 1, caractérisé en ce que la position de l'élément mémoire désignée par les moyens de désignation d'écriture (21) sur la base de la sortie du moyen d'opération logique dans les moyens d'établissement de code initial (31), est séparée par près de la moitié du nombre d'éléments mémoire à partir de la position de l'élément mémoire désignée par les moyens de désignation de lecture (23).

3. Circuit mémoire tampon selon la revendication 1, caractérisé en ce que les moyens de désignation d'écriture (21) sont prévus pour fonctionner d'une manière telle qu'un OU exclusif d'une paire de codes de position mémoire pour désigner les éléments mémoire dont l'intervalle entre ceux-ci est près de la moitié du nombre de tous les éléments mémoire a toujours une valeur prédéterminée.

FIG.1
PRIOR ART

1 MEMORY PORTION

INPUT DATA

#0
MEMORY ELEMENT
0

#1
MEMORY ELEMENT
1

#n-1
MEMORY ELEMENT
n-1

SELECTOR ~13

OUTPUT DATA

DECODER 9
#0 #1 #n-1

READING POSITION CODE

INPUT CLOCK PULSE
m

WRITING POSITION CODE

OUTPUT CLOCK

WRITING POINTER 3

ERROR DETECTOR

READING POINTER ~5

ERROR DETECTION SIGNAL

INITIAL CODE FOR WRITING

7

INITIAL CODE FOR READ OUT

RESET SIGNAL

EP 0 383 260 B1

# FIG. 2
PRIOR ART

READING POINTER

INCREMENT DIRECTION

11 0 1

10 2

9 MEMORY
ELEMENT
NUMBER 3 ○ MEMORY ELEMENT

8 4

7 6 5

INCREMENT
DIRECTION

WRITING POINTER

# FIG. 3
PRIOR ART

ERROR OCCUR

INPUT CLOCK
PULSE

OUTPUT CLOCK
PULSE

WRITING
POSITION

| $\alpha-1$ | $\alpha$ | $\alpha+1$ |

READING
POSITION

| $\alpha-1$ | $\alpha$ | $\alpha+1$ |

WRITING COMPLETED
TIME

READING COMPLETED
TIME

# FIG.4
## PRIOR ART

ERROR OCCUR

INPUT CLOCK PULSE

OUTPUT CLOCK PULSE

WRITING POSITION — $\alpha$

READING POSITION — $\alpha$

WRITING COMPLETED TIME

READING COMPLETED TIME

# FIG.5
## PRIOR ART

ERROR OCCUR

INPUT CLOCK PULSE

OUTPUT CLOCK PULSE

WRITING POSITION — $\alpha-1$ | $\alpha$ | $\alpha+1$

READING POSITION — $\alpha-1$ | $\alpha$ | $\alpha+1$

WRITING COMPLETED TIME FOR NEW DATA

READING COMPLETED TIME FOR DATA BEFORE n CLOCK PULSES

12

# FIG. 6

# FIG.7

| MEMORY ELEMENT# | POSITION CODE | ERROR DETEC-TION CODE, END POSITION DETECTION CODE | WRITING INITIAL CODE |
|---|---|---|---|
| 0 | 0 0 0 0 | 0 0 0 × | 1 0 1 0 |
| 1 | 0 0 0 1 |  | 1 0 1 1 |
|  |  | 0 0 × 1 |  |
| 2 | 0 0 1 1 |  | 1 0 0 1 |
|  |  | 0 0 1 × |  |
| 3 | 0 0 1 0 |  | 1 0 0 0 |
|  |  | 0 × 1 0 |  |
| 4 | 0 1 1 0 |  | 1 1 0 0 |
|  |  | × 1 1 0 |  |
| 5 | 1 1 1 0 |  | 0 1 0 0 |
|  |  | 1 × 1 0 |  |
| 6 | 1 0 1 0 |  | 0 0 0 0 |
|  |  | 1 0 1 × |  |
| 7 | 1 0 1 1 |  | 0 0 0 1 |
|  |  | 1 0 × 1 |  |
| 8 | 1 0 0 1 |  | 0 0 1 1 |
|  |  | 1 0 0 × |  |
| 9 | 1 0 0 0 |  | 0 0 1 0 |
|  |  | 1 × 0 0 |  |
| 10 | 1 1 0 0 |  | 0 1 1 0 |
|  |  | × 1 0 0 |  |
| 11 | 0 1 0 0 |  | 1 1 1 0 |
| 0 | 0 0 0 0 | 0 × 0 0 | 1 0 1 0 |

X : OPTIONAL

# FIG. 8

OUTPUT CLOCK PULSE

READING POINTER | 0100 | 0000 | 0001 | 0011

ERROR DETECTION CODE | 000×

ERROR CHECK SIGNAL

# FIG. 9

| | | | | | | |
|---|---|---|---|---|---|---|
| INPUT CLOCK PULSE | | | | | | |
| OUTPUT CLOCK PULSE | | | | | | |
| WRITING POINTER | 1000 | 1100 | 0100 | 0000 | 0001 | 0011 | 0010 |
| READING POINTER | 1011 | 1001 | 1000 | 1100 | 0100 | 0000 | 0001 | 0011 | 0010 |
| (a) ERROR CHECK SIGNAL (0×00) | | | | | | |
| (b) ERROR CHECK SIGNAL (000×) | | | | | | |
| (c) ERROR CHECK SIGNAL (00×1) | | | | | | |
| ERROR DETECTION SIGNAL | | | | | | |

EP 0 383 260 B1

# F I G. 10

INPUT CLOCK PULSE

OUTPUT CLOCK PULSE

END POSITION "0011"

READING POINTER 0001 "0011" 0010 0110

END POSITION DETECTION CODE "001×"

END POSITION DETECTION SIGNAL

I Y I : UNSTABLE